(19) **Europäisches Patentamt**

**European Patent Office**

**Office européen des brevets**

(11) **EP 1 374 518 B1**

(12) **EUROPÄISCHE PATENTSCHRIFT**

(45) Veröffentlichungstag und Bekanntmachung des Hinweises auf die Patenterteilung:
**14.12.2005 Patentblatt 2005/50**

(51) Int Cl.$^7$: **H04L 27/36**, H03C 3/40

(21) Anmeldenummer: 02719698.9

(22) Anmeldetag: **16.01.2002**

(86) Internationale Anmeldenummer:
**PCT/EP2002/000398**

(87) Internationale Veröffentlichungsnummer:
**WO 2002/082756 (17.10.2002 Gazette 2002/42)**

(54) **SIGNALVERARBEITUNG EINES AMPLITUDEN- UND/ODER PHASENMODULIERTEN HOCHFREQUENZSIGNALS NACH DEM PRINZIP DER ENVELOPE ELIMINATION UND RESTORATION**

SIGNAL PROCESSING OF AN AMPLITUDE-MODULATED AND/OR PHASE-MODULATED HIGH-FREQUENCY SIGNAL ACCORDING TO THE PRINCIPLE OF ENVELOPE ELIMINATION AND RESTORATION

MISE EN FORME D'UN SIGNAL HAUTE FREQUENCE MODULE EN AMPLITUDE ET/OU EN PHASE SELON LE PRINCIPE DE L'ELIMINATION ET DE LA RESTAURATION D'ENVELOPPE

(84) Benannte Vertragsstaaten:
**DE ES FR GB IT**

(30) Priorität: **07.04.2001 DE 10117563**

(43) Veröffentlichungstag der Anmeldung:
**02.01.2004 Patentblatt 2004/01**

(73) Patentinhaber: **Interessengemeinschaft für Rundfunkschutzrechte GmbH Schutzrechtsverwertung & Co. KG. 40210 Düsseldorf (DE)**

(72) Erfinder: **ZSCHUNKE, Willmut 64285 Darmstadt (DE)**

(74) Vertreter: **Eichstädt, Alfred Maryniok & Partner, Kuhbergstrasse 23 96317 Kronach (DE)**

(56) Entgegenhaltungen:
**EP-A- 0 708 545          EP-A- 0 942 563
EP-A- 0 998 088**

**Beschreibung**

Die Erfindung betrifft ein Verfahren zur Signalverarbeitung eines amplituden- und/oder phasenmodulierten Hochfrequenzsignals (RF-Signal) mit den im Oberbegriff des Anspruchs 1 angegebenen Merkmalen sowie eine Schaltungsanordnung zur Durchführung des Verfahrens

Ein gattungsgemäßes Signalverarbeitungsverfahren ist aus der EP 0 708 545 A2 bekannt. Das zu übertragende Signal liegt dabei in digitalisierter Form vor. Nacheinander werden mehrstufige Symbole aus einem, im Signal enthaltenen, vorgegebenen, komplexwertigen Symbolalphabet ausgewählt. Die reellen komplexen Komponenten der ausgewählten Symbole werden sodann durch eine Filterung in der Bandbreite begrenzt. Aus den bandbegrenzten Signalen werden Betrags- und Phasensignale bestimmt, die der modulierenden Endstufe getrennt zugeführt werden. Um die Division durch 0 nicht vornehmen zu müssen, werden Signalkonstellationen verwendet, die den Wert 0 vermeiden. Bei der Bandbegrenzung mit den Eingangsfiltern können Signalübergänge gegeben sein, die durch 0 gehen. Für die dabei gegebene Problematik ist der Schrift kein Lösungsansätz zu entnehmen.

Aus der EP 0 942 563 A2 ist ebenfalls eine Schaltungsanordnung bekannt, die nach dem gattungsgemäßen Verfahren arbeitet. Auch diese bekannte Schaltung gibt keine Anregung zur Signalverarbeitung im Falle, dass die Hüllkurve des modulierten zu verstärkenden Signals gegen oder durch Null geht.

Es ist ferner bekannt, dass Signale mit einer konstanten Hüllkurve sehr leistungseffizient in nichtlinearen Endstufen verstärkt werden können, was z.B. beim GSM-Verfahren ausgenützt wird. Der Verstärker kann dabei im sog. C-Betrieb betrieben werden, d.h. ohne Ruhestrom. Dadurch werden dann nur die positiven oder negativen Signalanteile zur Aussteuerung der Endstufe verwendet. Im Gegensatz dazu wird bei dem sog. A-Betrieb ein Arbeitspunkt im linearen Bereich der Verstärkerkennlinie gewählt, so dass positive und negative Signalanteile gleichermaßen verstärkt werden, wozu allerdings ein leistungsverbrauchender Arbeitspunkt gewählt werden muss. In Mobilfunkgeräten, GSM-Geräten, UNITS-Geräten und anderen ist ein leistungssparender Endstufenbetrieb Voraussetzung für die Nutzungsdauer eines Gerätes mit einer Ladung einer Batterie bzw. eines Akkumulators. Aber nicht nur für Mobilgeräte sind leistungseffiziente Endstufen von Vorteil, sondern auch bei Rundfunksendern, die die Programmsignale mit hoher Leistung abstrahlen.

Die zukünftig vermehrte Nutzung des mobilen Funknetzes durch das UMTS-System (Universal Mobile Telecommunications Systems) sowie der für das UMTS definierten Frequenzbänder wird künftig Bandbreite immer kostbarer erscheinen lassen, so dass von Modulationsverfahren mit konstanter Hüllkurve abgegangen werden wird. Um die entsprechenden amplituden- und phasenmodulierten Signale effizient verstärken zu können, kämen lineare Verstärker in Frage, die aber nicht leistungseffizient sind.

Eine Übersicht über gängige Verstärkungstechniken für Handtelefone oder mobile lineare Rundfunkleistungsverstärker sind in der Firmenbroschüre der Fa. Wireless Systems International Ltd. in Bristol, UK, (erschienen 1998) mit dem Titel "Amplifier and Transmitter Linearisation Techniques Explained" von Peter B. Kennington beschrieben.

In dieser Schrift, Abschnitt 5. "Envelope Elimination and Restoration (EE&R)" , ist eine leistungseffiziente Verstärkung angesprochen, die im Rahmen der vorliegenden Erfindung für Mobilfunkgeräte der nächsten Generation untersucht worden ist. Der zur Anwendung kommende hocheffiziente RF=Signal-Verstärker wirkt wie ein linearer Verstärker, ist aber aus leistungseffizienten nichtlinearen Verstärkern , z.B. der Klasse D, E oder F, zusammengesetzt.

Auch aus "PROCEEDINGS OF THE I.R.E." 1952, Seiten 803 - 806, sind derartige leistungseffiziente Verstärker bekannt. Das amplituden- und phasenmodulierte Signal wird in zwei Teile zerlegt: in das Hüllkurvensignal und das phasenmodulierte Signal mit konstanter Hüllkurve. Beide Signale können leistungseffizient mit Schaltverstärkern oder Klasse-C-Verstärkern verstärkt werden. Mit dem verstärkten Hüllkurvensignal wird die Verstärkung des Ausgangsverstärkers gesteuert. Dies kann z.B. über die Betriebsspannung des Verstärkers geschehen. Da zwischen beiden Spannungen im allgemeinen ein nichtlinearer Zusammenhang herrscht, ist ein Konverter vorzusehen, der in Prinzipbildern üblicherweise nicht gezeichnet wird. Die bekannte Verstärkertechnologie ist dann einsetzbar, wenn die Hüllkurve den Wert 0 nicht erreicht. Wenn die Hüllkurve hingegen zu Null wird, kann der vorgeschlagene Verstärker nicht mehr arbeiten.

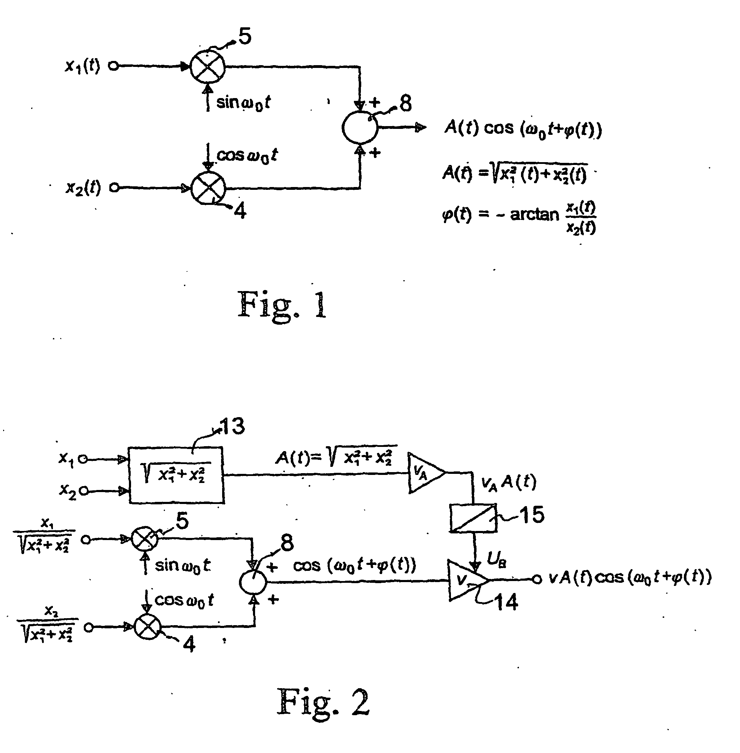

In "Microwave Symposium Digest", 1999 IEEE MTT-S International, Volume 2, 1999, Seite 811-814, ist ein Verfahren nach dem Prinzip der "Envelope Elimination and Restoration" ebenfalls beschrieben. Bei diesem Verfahren werden, wie auch bei den vorher beschriebenen EE&R-Verfahren, immer das Hüllkurvensignal und das rein phasenmodulierte Signal gebildet, wobei letzteres, wie üblich, durch Begrenzung gewonnen wird. Die Wirkungsweise der in Figur 1 auf Seite 811 angegebenen DSP-Signalquelle ist nicht näher beschrieben.

Aus dem FM-Signal werden nach den bekannten Verfahren mittels Spitzenwertdetektion ein Hüllkurvensignal und durch Begrenzung ein phasenmoduliertes Signal $\cos(\omega_0 t + \varphi())$ gebildet. Im Falle, dass das Hüllkurvensignal gegen Null geht, ist die Bildung des phaserimodulierten Signals bei dieser Technologie mit Problemen behaftet, wie vorher schon angegeben. Ein weiteres Problem ist die Sicherstellung der notwendigen Linearität zwischen dem verstärkten Hüllkurvensignal und dem Verstärkerverhalten des FM-Verstärkers.

Ausgehend vom Stand der Technik liegt der Erfindung die Aufgabe zugrunde, ein Verfahren.und eine Schaltung anzugeben, die besonders leistungseffizient für Datensignale ist und es erlaubt, modulierte Signale zu verstärken, sogar für den Fall, dass ihre Hüllkurve gegen oder durch Null geht.

Gelöst wird die Aufgabe durch das im Anspruch 1 angegebene Verfahren sowie durch Realisierung einer Schaltung gemäß Anspruch 5 zur Durchführung des Verfahrens.

Vorteilhafte Verfahrensschritte, die ergänzend berücksichtigt werden können, sind in den Unteransprüchen 2 bis 4 angegeben. Das Verfahren ist auch für eine Signalverarbeitung für reine Amplitudenmodulation (Rundfunk) ebenfalls verwendbar. Für diesen Fall ist eines der beiden Eingangssignale ($x_1$ oder $x_2$) Null.

Die Erfindung wird nachfolgend anhand der in der Zeichnung dargestellten Figuren ergänzend erläutert.

Figur 1 zeigt eine Anordnung zur allgemeinen Realisierung amplituden- und phasenmodulierter Signale durch eine Quadraturmodulation. Die Signale $x_1(t)$ und $x_2(t)$ sind beim Mobilfunkverfahren üblicherweise in Speichern (ROM) als Abtastwerte-abgelegt. Die beiden Ausgangssignale der Multiplizierer 4 und 5 werden im Addierer 8 zum Ausgangssignal $A(t)\cos(\omega_0 t + \varphi(t))$ zusammengeführt.

Figur 2 zeigt eine erfindungsgemäße Schaltungsanordnung zur Bildung des Hüllkurvensignals und des phasenmodulierten Signals nach dem Prinzip von "Envelope Elimination and Restoration". Das amplituden- und phasenmodulierte Signal ist in zwei Teile zerlegt dargestellt, wobei das amplitudenmodulierte Signal das Hüllkurvensignal $A(t)$ und das phasenmodulierte Signal $\cos(\omega_0 t + \varphi(t))$ ein solches mit konstanter Hüllkurve ist. Beide Signale können leistungseffizient mit Schaltverstärkern oder Klasse-C-Verstärkern verstärkt werden. Mit dem verstärkten Hüllkurvensignal wird die Verstärkung des unteren Verstärkers gesteuert. Dies kann z.B. über die Betriebsspannung $U_B$ des Verstärkers 14 geschehen. Da zwischen beiden Spannungen im allgemeinen ein nichtlinearer Zusammenhang herrscht, ist ein Konverter 15 vorzusehen, der in Prinzipbildern üblicherweise nicht gezeichnet wird.

Realisiert wird die Signalverarbeitung zum Gewinnen eines modifizierten Eingangssignals durch Erzeugen eines Hüllkurvensignals mittels einer betragsbildenden Schaltung 13 aus den beiden Eingangssignalen $x_1$ oder $x_2$, z. B. durch Tabellensuchen. Das rein phasenmodulierte Signal $\cos(\omega_0 t + \varphi(t))$ mit konstanter Amplitude wird mittels eines Quadratur-Amplitudenmodulators durch Division der beiden Eingangssignale $x_1$ und $x_2$ durch den ermittelten Betragswert $A(t)$ des Hüllkurvensignals gebildet. Die Amplitude $A(t)$ wird, wie im oberen Teil der Figur 2 gezeigt, durch die betragsbildende Signalverarbeitung gewonnen. Nähern sich $x_1$ und $x_2$ dem Wert Null ($A(t) \to 0$), so ergeben sich Ausdrücke der Form 0/0, wie nachfolgende mathematische Abhandlung belegt.

$$x_1; x_2 \to 0$$

$$\lim_{x_1, x_2 \to 0} \frac{x_1(t)}{A(t)} \qquad \text{und} \qquad \lim_{x_1, x_2 \to 0} \frac{x_2(t)}{A(t)}$$

Dies kann auf einfache Weise durch Anwendung der Taylor-Reihenexpansion in der Zeit t von $x_1(t)$ und $x_2(t)$ erreicht werden. Beachtend, dass

$$\lim_{A(t) \to 0} \frac{dA(t)}{dt} < 0$$

wird, wenn die Amplitude verringert wird, ist aus obigen Ausdrücken ableitbar:

$$\lim_{x_1, x_2 \to 0} \frac{x_1}{\sqrt{x_1^2 + x_2^2}} = \frac{\dot{x}_1}{-\sqrt{\dot{x}_1^2 + \dot{x}_2^2}}$$

$$\lim_{x_1, x_2 \to 0} \frac{x_2}{\sqrt{x_1^2 + x_2^2}} = \frac{\dot{x}_2}{-\sqrt{\dot{x}_1^2 + \dot{x}_2^2}}$$

wobei

$$\dot{x} = \frac{dx}{dt}$$

ist.

Wenn $x_1$ und $x_2$ Abtastwerte während eines Zeitintervalls T sind und 0 bei der Probe n ($x_{1,n} = x_{2,n} = 0$) sind, lassen sich folgende Ableitungen aufstellen:

$$\dot{x}_{1,n} = \frac{x_{1,n} - x_{1,n-1}}{T} = \frac{-x_{1,n-1}}{T}$$

und

$$\dot{x}_{2,n} = \frac{x_{2,n} - x_{2,n-1}}{T} = \frac{-x_{2,n-1}}{T}$$

Die Größe des Grenzwertes ist mithin

$$\lim_{x_1,x_2 \to 0} \frac{x_1}{\sqrt{x_1^2 + x_2^2}} = \frac{x_{1,n-1}}{\sqrt{x_{1,n-1}^2 + x_{2,n-1}^2}} .$$

und

$$\lim_{x_1,x_2 \to 0} \frac{x_2}{\sqrt{x_1^2 + x_2^2}} = \frac{x_{2,n-1}}{\sqrt{x_{1,n-1}^2 + x_{2,n-1}^2}}$$

Dies sind die Werte der letzten Proben im Fall $x_1 = x_2 = 0$. Im Falle, dass das Hüllkurvensignal A(t) gegen Null geht, können dieselben Grenzbetrachtungen angestellt werden.

Beim Grenzübergang müssen die Eingangssignale ersetzt werden durch

$$- \frac{\dot{x}_1}{\sqrt{\dot{x}_1^2 + \dot{x}_2^2}} \text{ und } - \frac{\dot{x}_2}{\sqrt{\dot{x}_1^2 + \dot{x}_2^2}}$$

Diese Ableitung wird aus den abgespeicherten Abtastwerten der Signale x durch Differenzbildung zeitlich benachbarter x-Werte gewonnen. Wenn die x-Werte unter eine nicht mehr verarbeitbare Schwelle fallen, werden statt ihrer die Differenzwerte eingesetzt. Die Berechnung der modifizierten Eingangssignale und der Amplitude A(t) kann entweder in einem DSP erfolgen oder für die vorkommenden x-Werte durch umgerechnete Signale, die in einer Tabelle abgelegt sind (Table-Look-Up), ermittelt werden. Das Ausgangssignal am Addierer 8 wird im Verstärker 14 in Abhängigkeit vom verstärkten Betragswert der Hüllkurve verstärkt.

**Patentansprüche**

1.  Verfahren zur Verstärkung eines amplituden- und/ oder phasenmodulierten Hochfrequenzsignals nach dem Prinzip des "Envelope Elimination and Restoration", wobei das Hüllkurvensignal und das phasenmodulierte, Signal durch Signalverarbeitung aus zwei Eingangsignalen mittels folgender Verfahrensschritte gewonnen werden:

    a) Durchführen einer Betragsdetektion der beiden Eingangssignale ($x_1, x_2$) mittels betragsbildender Signalverarbeitung zur Bildung eines Hüllkurvensignals (A(t));

    b) Durchführen einer Division der beiden Eingangsignale. ($x_1, x_2$) durch den ermittelten Betragswert des Hüllkurvensignals (A(t));

    c) Durchführen einer Multiplikation des einen Divisionssignals ($x_1/\sqrt{x_1^2 + x_2^2}$) mit $\sin \omega_0 t$ und des anderen Divisionssignals ($x_2/\sqrt{x_1^2 + x_2^2}$) mit $\cos \omega_0 t$;

    d) Bilden eines rein phasenmodulierten Summensignals ($\cos(\omega_0 t + \varphi(t))$ aus den beiden multiplizierten Signalen;

    e) Verstärken des phasenmodulierten Summensignals durch das Hüllkurvensignal mit einem Verstärkungsfaktor (v) zur Bildung eines RF-Ausgangssignals ($vA(t)\cos(\omega_0 t + \varphi(t))$),

    **dadurch gekennzeichnet,**
    **dass** die Eingangssignale ($x_1$ (t) und $x_2$(t)) Abtastwerte sind und
    **dass** bei Annäherung der Abtastwerte der Eingangssignale ($x_1$ und $x_2$) gegen oder durch Null oder wenn das Hüllkurvensignal (A(t)) gegen oder durch Null geht, die Eingangssignale ($x_1$ und $x_2$) durch mittels Differenzbildung benachbarter Abtastwerte modifizierte Eingangssignale ersetzt werden.

2.  Verfahren nach Anspruch 1, **dadurch gekennzeichnet, dass** das RF-Ausgangssignal ein phasenmoduliertes Signal mit konstanter oder sich ändernder Hüllkurve ist.

3.  Verfahren nach Anspruch 1, **dadurch gekennzeichnet, dass** bei Anwendung des Verfahrens für ein rein amplitudenrnoduliertes Signal eines der beiden Signale ($x_1$ oder $x_2$) Null ist.

4.  Verfahren nach Anspruch 1, **dadurch gekennzeichnet, dass** die Abtastwerte der Eingangssignale und die zugehörigen modifizierten Eingangssignale in einer Tabelle abgelegt sind und die modifizierten Eingangsabtastwerte bei Unterschreiten einer bestimmten vorgegebenen Schwelle des Amplitudenwertes des Hüllkurvensignals als Ersatzwert aus der Tabelle ausgelesen werden.

5.  Schaltungsanordnung zur Durchführung des Verfahrens nach Anspruch 1, mit einer zur Bildung des Hüllkurvensignals vorgesehenen ersten Schaltung (13) zur Betragsbildung aus den Eingangssignalen ($x_1$ und $x_2$) und einer zweiten Schaltung zur Bildung des rein phasenmodulierten Signals, in der die Eingangssignale ($x_1$ und $x_2$) durch den Betragswert (A(t)) des Hüllkurvensignals dividiert und mit den Multiplizierern (4, 5) mit $\cos\omega_0 t$ und $\sin\omega_0 t$ multipliziert werden, wobei die Ausgangssignale an einem Addierer (8) anliegen und vom Ausgang des Addierers (8) das phasenmodulierte Signal abgreifbar ist, das mittels eines Verstärkers (14), der in Abhängigkeit von dem Hüllkurvensignal steuerbar ist, verstärkt wird, **dadurch gekennzeichnet, dass** ein digitaler Signalprozessor vorgesehen ist, der die Berechnung der Abtastwerte modifizierter Eingangssignale durchführt und bei Annäherung der Abtastwerte der Eingangssignale ($x_1$ und $x_2$) gegen oder durch Null oder wenn das Hüllkurvensignal (A(t)) gegen oder durch Null geht, die Eingangssignale ($x_1$ und $x_2$) durch mittels Differenzbildung benachbarter, Abtastwerte modifizierte Eingangssignale ersetzt, wobei die Abtastwerte der Eingangssignale und die zugehörigen modifizierten Eingangssignale in einer Tabelle abgelegt sind und die modifizierten Eingangsabtastwerte bei Unterschreiten einer bestimmten vorgegebenen Schwelle des Amplitudenwertes des Hüllkurvensignals als Ersatzwert aus der Tabelle ausgelesen werden.

## Claims

1. Method of amplification of an amplitude-modulated and/or phase-modulated highfrequency signal according to the principle of, 'envelope elimination and restoration, wherein the envelope signal and the phase-modulated signal are obtained by signal processing from two input signals by means of the following method steps:

    a) carrying out an amount detection of the two input signals ($x_1$, $x_2$) by means of amount-forming signal processing for formation of an envelope signal (A(t));

    b) carrying out division of the two input signals ($x_1$, $x_2$) by the ascertained amount value of the envelope signal (A(t));

    c) carrying out multiplication of one division signal ($x_1/\sqrt{x_1^2 + x_2^2}$) by sin $\omega_0 t$ and of the other division signal ($x_2/\sqrt{x_1^2 + x_2^2}$) by cos $\omega_0 t$;

    d) forming a pure phase-modulated summation signal ($\cos(\omega_0 t + \varphi(t))$ from the two multiplied signals; and

    e) amplifying the phase-modulated summation signal by the envelope signal with an amplification factor (v) for formation of an RF output signal ($v$A($t$)cos($\omega_0 t + \varphi(t)$)),

    **characterised in that** the input signals ($x_1$(t) and $x_2$(t)) are scanning values and that in the case of approach of the scanning values of the input signals ($x_1$ and $x_2$) towards or through zero or if the envelope signal (A(t)) goes towards or through zero the input signals ($x_1$ and $x_2$) are replaced by input signals modified by means of difference formation of adjacent scanning values.

2. Method according to claim 1, **characterised in that** the RF output signal is a phase-modulated signal with constant or changing envelope.

3. Method according to claim 1, **characterised in that** in the case of use of the method for a pure amplitude-modulated signal one of the two signals ($x_1$ or $x_2$) is zero.

4. Method according to claim 1, **characterised in that** the scanning values of the input signals and the associated modified input signals are filed in a table and the modified input scanning values are read out of the table as replacement value in the case of falling below of a specific predetermined threshold of the amplitude value of the envelope signal.

5. Circuit arrangement for carrying out the method according to claim 1, with a first circuit (13), which is provided for formation of the envelope signal, for amount formation from the input signals ($x_1$ and $x_2$) and a second circuit for formation of the pure phase-modulated signal, in which the input signals ($x_1$ and $x_2$) are divided by the amount value (A(t)) of the envelope signal and multiplied by the multipliers (4, 5) by cos $\omega_0 t$ and sin $\omega_0 t$, wherein the output signals are applied to an adder (8) and the phase-modulated signal can be tapped from the output of the adder (8), which signal is amplified by means of an amplifier (14) controllable in dependence on the envelope signal, **characterised in that** a digital signal processor is provided, which carries out calculation of the scanning values of modified input signals and on approach of the scanning values of the input signal ($x_1$ and $x_2$) towards or through zero or when the envelope signal (A(t)) goes towards or through zero the input signals ($x_1$ and $x_2$) are replaced by input signals modified by means of difference formation of adjacent scanning values, wherein the scanning values of the input signals and the associated modified input signals are filed in a table and the modified input scanning values are read out of the table as replacement value in the case of falling below of a specific predetermined threshold of the amplitude value of the envelope signal.

## Revendications

1. Procédé pour amplifier un signal à haute fréquence modulé en amplitude et/ou en phase, selon le principe "Enveloppe Elimination and Restoration", selon lequel le signal de la courbe enveloppe et le signal modulé en phase sont obtenus par traitement à partir de deux signaux d'entrée à l'aide des étapes opératoires suivantes :

    a) exécution d'une détection de la valeur absolue des deux signaux d'entrée ($x_1$,$x_2$) à l'aide d'une unité de traitement de signal, formant la valeur absolue, pour la formation d'un signal de courbe enveloppe (A(t));

b) exécution d'une division des deux signaux d'entrée ($x_1$, $x_2$) par la valeur absolue déterminée du signal de courbe enveloppe (A(t));

c) exécution d'une multiplication d'un signal de division ($x_1/\sqrt{x_1^2 + x_2^2}$) par $\sin \omega_0 t$ et de l'autre signal de division ($x_2/\sqrt{x_1^2 + x_2^2}$) par $\cos\omega_0 t$;

d) formation d'un signal de somme purement modulé en phase ($\cos(\omega_0 t + \varphi(t))$ à partir des deux signaux multipliés;

e) amplification du signal de somme modulé en phase par le signal de courbe enveloppe avec un facteur d'amplification (v) pour former un signal de sortie RF ($vA(t)\cos(\omega_0 t + \varphi(t))$),

**caractérisé en ce que** les signaux d'entrée ($x_1(t)$ et $x_2(t)$) sont des valeurs d'échantillonnage, et

**que** lorsque les valeurs d'échantillonnage des signaux d'entrée ($x_1$ et $x_2$) se rapprochent de zéro ou passent par zéro ou lorsque le signal de courbe enveloppe (A(t)) tend vers zéro ou passe par zéro, les signaux d'entrée ($x_1$ et $x_2$) sont remplacés par des signaux d'entrée modifiés à l'aide de la formation de la différence de valeurs d'échantillonnage voisines.

2. Procédé selon la revendication 1, **caractérisé en ce que** le signal de sortie RF est un signal modulé en phase comportant une courbe enveloppe constante ou qui varie.

3. Procédé selon la revendication 1, **caractérisé en ce que**, dans le cas de l'utilisation du procédé pour un signal purement modulé en amplitude, l'un des deux signaux ($x_1$ ou $x_2$) est nul.

4. Procédé selon la revendication 1, **caractérisé en ce que** les valeurs d'échantillonnage des signaux d'entrée et les signaux d'entrée modifiés associés sont placés dans un tableau et les valeurs d'échantillonnage d'entrée modifiées, lorsque les valeurs d'amplitude du signal de courbe enveloppe tombent au-dessous d'un certain seuil prédéterminé, sont lues en tant que valeur de remplacement à partir du tableau.

5. Montage pour la mise en oeuvre du procédé selon la revendication 1, comportant un premier circuit (13), prévu pour former le signal de courbe enveloppe et servant à former la valeur absolue à partir du signal d'entrée ($x_1$ et $x_2$), et un second circuit pour former le signal purement modulé en phase, dans lequel les signaux d'entrée ($x_1$ et $x_2$) sont divisés par la valeur absolue (A(t)) du signal de courbe enveloppe et sont multipliés par $\cos\omega_0 t$ et $\sin\omega_0 t$ au moyen des multiplieurs (4,5), les signaux de sortie étant appliqués à un additionneur (8) et le signal modulé en phase pouvant être prélevé sur la sortie de l'additionneur (8), signal qui est amplifié au moyen d'un amplificateur (14) qui peut être commandé en fonction du signal de courbe enveloppe, **caractérisé en ce qu'**il est prévu un processeur de signaux numériques, qui exécute le calcul des valeurs d'échantillonnage des signaux d'entrée modifiés et, lorsque les valeurs d'échantillonnage des signaux d'entrée ($x_1$ et $x_2$) se rapprochent de zéro ou passent par zéro ou lorsque le signal de courbe enveloppe (A(t)) tend vers zéro ou passe par zéro, remplace les signaux d'entrée ($x_1$ et $x_2$) par des signaux d'entrée modifiés au moyen de la formation de la différence de valeurs d'échantillonnage voisines, les valeurs d'échantillonnage des signaux d'entrée et les signaux d'entrée modifiés associés étant placés dans un tableau et, lorsque la valeur d'amplitude du signal de courbe enveloppe tombe au-dessous d'un certain seuil prédéterminé, les valeurs d'échantillonnage d'entrée modifiées sont lues en tant que valeurs de remplacement à partir du tableau.

$A(t) \cos (\omega_0 t + \varphi(t))$

$A(t) = \sqrt{x_1^2(t) + x_2^2(t)}$

$\varphi(t) = -\arctan \dfrac{x_1(t)}{x_2(t)}$

Fig. 1

Fig. 2